(19) Europäisches Patentamt
European Patent Office
Office européen des brevets

(11) **EP 2 306 211 B1**

(12) **EUROPEAN PATENT SPECIFICATION**

(45) Date of publication and mention
of the grant of the patent:
**18.04.2012 Bulletin 2012/16**

(51) Int Cl.:
*G01R 3/00* *(2006.01)*    *G01R 15/24* *(2006.01)*
*G01R 33/032* *(2006.01)*

(21) Application number: **09171887.4**

(22) Date of filing: **30.09.2009**

(54) **Method for manufacturing a fiber optic current sensor with inherent temperature compensation of the Faraday effect**

Verfahren zur Herstellung eines Glasfaserstromsensors mit inhärentem Temperaturausgleich des Faraday-Effekts

Procédé de fabrication d'un capteur de courant à fibre optique doté d'une compensation inhérente de la température de l'effet de Faraday

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**06.04.2011 Bulletin 2011/14**

(73) Proprietor: **ABB Research Ltd.**
**8050 Zürich (CH)**

(72) Inventors:
• **Wüest, Robert**
**CH-8037, Zürich (CH)**
• **Frank, Andreas**
**CH-8037, Zürich (CH)**
• **Bohnert, Klaus**
**CH-5452, Oberrohrdorf (CH)**

• **Gabus, Philippe**
**CH-5210 Windisch (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(56) References cited:
**WO-A1-2005/111633     US-B2- 7 339 680**

• **BOHNERT K ET AL: "Temperature and Vibration Insensitive Fiber-Optic Current Sensor" JOURNAL OF LIGHTWAVE TECHNOLOGY, IEEE SERVICE CENTER, NEW YORK, NY, US, vol. 20, no. 2, 1 February 2002 (2002-02-01), XP011030114 ISSN: 0733-8724**

**Description**

Technical Field

The invention reflates to the manufacturing of a fiber optic current sensor (FOCS) that comprises a sensing fiber to be exposed to the magnetic field of a current to be measured. This type of sensor is typically used in high voltage substations of applications with high direct currents (dc).

Background Art.

Fiber-optic current sensors (FOCS) commonly rely on the Faraday effect in fused silica fibers. The Faraday-effect varies with temperature. The Verdet constant $V$ of fused silica fiber, which is a measure for the Faraday effect, changes according to $(1/V) \, \partial V/\partial T = 7 \times 10^{-5} °C^{-1}$, i.e. within a temperature range of operation of e.g. -40° to +80°C the sensor signal varies within 0.84%. Many applications of the sensor require accuracy to within $\pm 0.2\%$ or $\pm 01\%$, however, and therefore require measures for temperature compensation. In EP 1107029, EP 1115000 and Ref. [1] a method was described for inherent temperature compensation of the Faraday effect in interferometric Sagnac and reflection-type fiber-optic current sensors. The method of inherent compensation eliminates the need of an extra temperature sensor, which is particularly important for current sensing at high electric potentials. The method exploits the temperature dependence of the fiber-optic retarder which generates the normally circular light waves propagating in the sensing fiber. For temperature compensation the retardation is set to a value which differs by a non-zero amount $\varepsilon$ from the conventional 90°-retardation. The variation of the retardation with temperature affects the scale factor of the sensor. At the properly chosen retardation, e.g. $\varepsilon = 10°$, the influence of the retarder on the sensor sensitivity (normalized scale factor $S$) just balances the variation of the Verdet constant with temperature

According to the state-of the-art the retarder is initially prepared with an over-length, i.e. a retardation larger than the target retardation. The proper retardation is then approached by fine-tuning the retardation in a stepwise manner. After each fine-tuning step the retarder contribution to the temperature dependence of the sensor is measured. The measurement involves translating the retarder to a temperature controller, changing the retarder temperature within a certain range and monitoring the resulting effect on the sensor signal for a given current. The fine-tuning is continued until proper compensation is reached. Fine-tuning is done by heating the retarder in the arc or heater filament of a fiber splicer. The heating alters the retarder's linear birefringence and thus retardation, e.g. by diffusion of dopants out of the fiber core and/or by a change in fiber stress.

Disclosure of the Invention

The problem to be solved by the present invention is to provide a more efficient method of tuning the retarder for temperature compensation when manufacturing a FOCS.
This problem is solved by the method of claim 1.
Accordingly, the method is adapted to manufacture a fiber optic current sensor, which sensor comprises

- A sensing fiber to be exposed to a magnetic field of a current $I$ to be measured, wherein said sensing fiber has a Verdet constant $V$; the sensing fiber further has bend-induced birefringence or residual linear birefringence remaining after thermal annealing given rise to a birefringent phase retardation $\delta$ [1, 2]. This phase retardation $\delta$ depends on the type of the fiber, number and radius of the fiber loops, the preparation of the fiber (e.g. annealing, etc.) and it may be zero or non-zero.
- At least one fiber optical retarder coupled to said fiber for converting light between linear and elliptical polarization, wherein a slow axis of said retarder is at an angle 45° - $\beta$ in respect to a slow axis of said sensing fiber; the retarder induces a differential retardation $\rho$ dependent on temperature with

$$Q = \frac{1}{\rho} \cdot \frac{\partial \rho}{\partial T};$$

- A control unit generating a sensor signal a dependent on a current-induced phase shift $\Delta\phi$, in particular proportional to said phase shift $\Delta\phi$, which phase shift can be written as

$$\Delta\phi = 4\,S\,\cdot\varphi_F$$

with $\varphi_F = V\cdot N\cdot I$, and wherein $N$ is a number of loops of said sensing fiber and $S$ is a scale factor.

The method according to the invention comprises the steps of:

- Exposing said sensing fiber to a magnetic field;
- In an initial step measuring an initial dependence $A$

$$A = \frac{1}{\sigma}\cdot\frac{\partial\sigma}{\partial T}$$

 of said sensor signal $\sigma$ on a temperature $T$ of said retarder;
- Defining a target dependence $B$

$$B = \frac{1}{\sigma}\cdot\frac{\partial\sigma}{\partial T}$$

of the sensor signal $\sigma$ on a temperature T of said retarder;
- Determining, from $A$, $B$, $Q$ $\delta$ and $\beta$, a ratio $r$ with

$$r = \frac{\sigma_{fin}}{\sigma_{ini}}$$

between an initial measured signal $\sigma_{ini}$ at a stage before a thermal treatment of the retarter and a target signal $\sigma_{fin}$ at a final stage after a thermal treatment of the retarder; $\sigma_{ini}$ and $\sigma_{fin}$ are measured with the same values of $\delta$, $\beta$ and $\varphi_F$.
- Subjecting said retarder to a thermal treatment and measuring said signal $\sigma$ until said signal has substantially changed by said ratio $r$.

Accordingly, the method according to the invention obviates the need to explicitly measure the temperature dependence of $\sigma$ repetitively during thermal treatment of the fiber It merely requires that the signal $\sigma$ as caused by the magnetic field is being monitored, until that signal has changed by said ratio $r$ (or, at least, by a value close to said ratio $r$).

The ratio r can be calculated such that

$$r(A,B,Q_1,Q_2) = \frac{S\left(B/Q_2,\delta,\beta\right)}{S\left(A/Q_1,\delta,\beta\right)}$$

with $S$ being a scale factor calculated e.g. by using the equations (3)-(5) below, or an equivalent description, or a linear approximation thereof (e.g. Eq. (6)) for small current induced phase shifts. The quantity $\varepsilon$ in equations (3)-(5) (or Eq. (6)) can be calculated with a second order approximation such that

$$\varepsilon = \frac{-b+\sqrt{b^2-4ac}}{2a}$$

with

$$a = 1 + \frac{1}{2}X - \sin(2\beta)\delta\frac{\pi}{4}$$

$$b = \frac{\pi}{2} + \sin(2\beta)\delta(1 + X)$$

$$c = \sin(2\beta)\delta\frac{\pi}{2} - X$$

wherein $X = A/Q_1$ when calculating $S$ before thermal treatment and $X = B/Q_2$ when calculating $S$ after thermal treatment, wherein $Q_1$ and $Q_2$ denote values of $Q$ before and after the thermal treatment. In general, $Q_1$ and $Q_2$ are not equal and, advantageously, at least one of them has been determined prior to manufacturing the sensor. A method to measure $Q_1$ and $Q_2$ is described below.

Other advantageous embodiments are listed in the dependent claims as well as in the description below.

Brief Description of the Drawings

The invention will be better understood and objects other than those set forth above will become apparent from the following detailed description thereof. Such description makes reference to the annexed drawings, wherein:

Fig. 1 is a diagram of a fiber-optic current sensor,
Fig. 2 shows an embodiment of a fiber-optic retainer,
Fig. 3 illustrates the rotational position of the retarder in respect to the sensing fiber plane,
Fig. 4 the normalized scale factor as a function of retardation $\rho$,
Fig. 5 a set-up for characterizing the retarder, and
Fig. 6 shows the scale factor $S$ as a function of $4\varphi_F$ for three different retarder settings $\rho$ at retarder temperatures $T$ of -40°C, 20°C and 80°C, $\delta = 0$.

Modes for Carrying Out the Invention

*Sensor design*

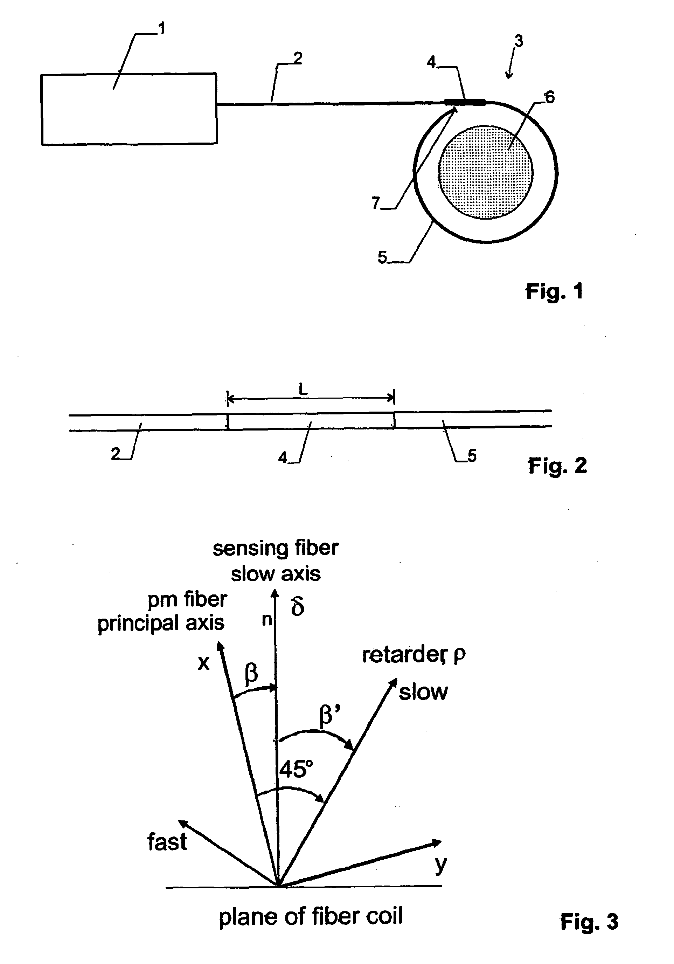

The working principle of a fiber-optic current sensor as described in [1] is depicted in Fig. 1. Two orthogonal linearly polarized light waves are sent from a control unit 1 through a connecting polarization-maintaining fiber (pm fiber) 2 to a sensing head, generally denoted by 3. Sensing head 3 comprises an optical retarder 4, a sensing fiber 5 and a reflector 7.

Retarder 4 is a fiber optic retarder and serves to convert between the linearly polarized light in pm fiber 2 and elliptically polarized light in sensing fiber 5. It has two principal axes and its length is adapted to induce a differential phase shift $\rho = \pi/2 + \varepsilon$ between light waves polarized along its principal axes, with $\varepsilon$ being an additional, non-zero phase shift.

Commonly, sensing fiber 5 is looped $N > 0$ times around a conductor 6 the current $I$ in which is to be measured. Reflector 7 is arranged at the end of sensing fiber 5 for reflecting the light back through sensing fiber 5, retarder 4, pm fiber 2 into control unit 1. Right and left circular light waves have different phase velocities while traveling in the magnetic field alound the conductor due to the Faraday effect. As a result, the light waves acquire a phase difference $\Delta\phi$ given by

$$\Delta\phi = 4 \cdot \varphi_F = 4\ V \cdot N \cdot I \qquad\qquad (1)$$

Here, $V$ is the Verdet constant of the sensing fiber, $N$ is the number of sensing fiber loops around conductor 6, and $I$ is the current. Eq. (1) is valid for a fiber coil free of any linear birefringence ($\delta = 0$) and perfectly circular light waves ($\varepsilon = 0°$).

After being transformed back into linear polarizations by retarder 4, the magnetic field introduced phase difference is measured by control unit 1, e.g. with a technique adapted from fiber-optic gyroscopes as described in Refs. [1],[4].

Retarder 4 is fabricated out of a polarization maintaining fiber (pm fiber) and spliced to the low birefringence sensing fiber (see Fig. 2) as e.g. described in EP 1107029. The retarder fiber may be made out of one of several types of pm fibers, e.g. elliptical core fibers or fibers with a stress-induced birefringence (Panda, Bowtie or elliptical cladding fibers).

As it was shown in WO 2005/111533 and Ref. [2], the magneto-optic phase shift $\Delta\phi$ of a temperature-compensated sensor ($\rho \neq 90°$) with linear fiber birefringence ($\delta \neq 0°$) is influenced not only by $I$, $V$, and $N$, but also by the following sensor head parameters: the retardation $\rho = \pi/2 + \varepsilon$ of the retarder, the birefringence $\delta$ in the sensing fiber and the azimuth angle $\beta$. The azimuth angle $\beta$ is shown in Fig. 3 as the angle between a first principal axis of the polarizaton maintaining (pm) fiber immediately before retarder 4 and the normal vector n of the plane of the coil of sensing fiber 5. In Fig. 2, the slow principal axis of the retarder fiber is oriented at +45° with respect to a first principal axis of the pm fiber immediately before the retarder as is shown in Fig. 3. Note that to make the definition of $\beta$ unambiguous, the principle axis of the pm fiber 2 is chosen such that the slow principal axis of the retarder fiber is oriented at +45° with respect to the first principal axis of the pm fiber 2. The slow principal axis of the retarder fiber is then oriented at -45° with respect to the other, second principal axis of the pm fiber 2.

The magneto-optic phase shift $\Delta\phi$ observed by the present device can, at least in linear approximation, i.e. for small magneto-optic phase shifts ($4 \, \varphi_F \ll 1$) , be written as

$$\Delta\phi = 4\,S(\varepsilon, \delta, \beta) \cdot V{\cdot}N{\cdot}I$$
$$\Delta\phi = 4\,S(\varepsilon, \delta, \beta)\,\varphi_F \qquad\qquad (2)$$

$S$ is a normalized scale factor which is equal to unity for $\varepsilon = 0°$ and $\delta = 0°$.

In the general case $\Delta\phi$ is given by [2]

$$\Delta\phi = \arctan\!\left(\frac{2U}{1-U^2}\right) \qquad\qquad (3)$$

with

$$U = \frac{2\varphi_F \dfrac{\tan(\Gamma)}{\Gamma}}{\cos(\varepsilon) - \delta\sin(\varepsilon)\sin(2\beta)\dfrac{\tan(\Gamma)}{\Gamma}}, \qquad\qquad (4)$$

$$\Gamma = \left[\delta^2 + (2\varphi_F)^2\right]^{1/2}, \qquad\qquad (5)$$

In principle, the sensing fiber may also exhibit some intrinsic fiber linear birefringence $\delta_i$, e.g. due to fiber anisotropies of intrinsic stress. Commonly, $\delta_i$ may be neglected for state-of-the-art low-birefringence sensing fibers, however, and is therefore not considered any further in the following.

For small Faraday phase shifts $\varphi_F$, i.e. $\varphi_F \ll 1$, and with approximations accurate to within roughly $\Delta S/S = 10^{-4}$, the normalized scale factor $S$ is given by [2]:

$$S\,(\varepsilon,\delta,\beta) = \frac{1 + \frac{1}{3}\delta^2}{\cos(\varepsilon) - \delta\sin(2\beta)\sin(\varepsilon)}\,. \qquad\qquad (6)$$

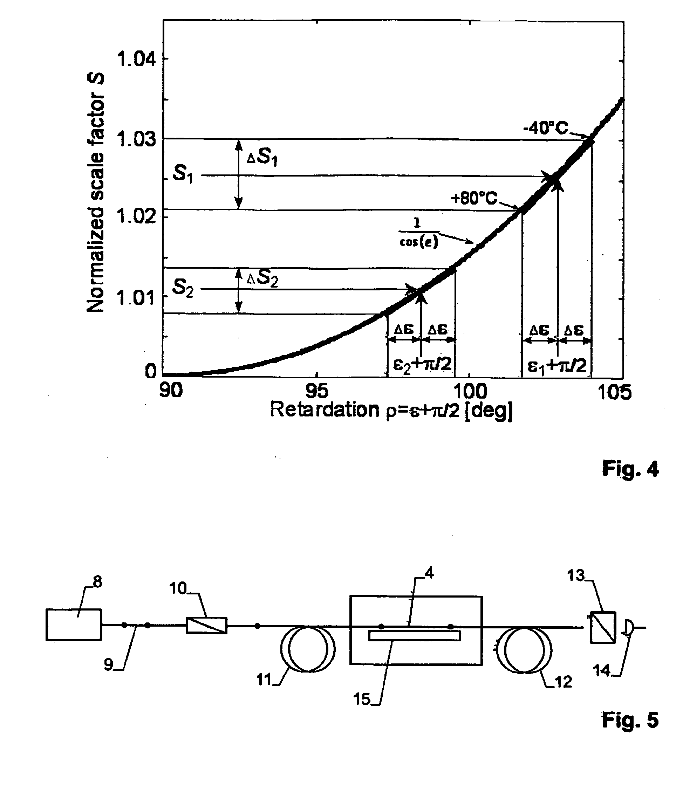

As mentioned, the retardation $\rho$ of retarder 4 differs by a proper amount $\varepsilon$ (e.g $\varepsilon = 10°$ for a particular type of retarder fiber) from the $\pi/2$-retardation of a perfect quarter-wave retarder, in order to compensate for the temperature dependence of the Verdet constant $V$, as illustrated in Fig. 4, i.e. the contribution $B$ of the retarder to the temperature dependence of the sensor offsets the contribution of the Verdet constant:

$$B = -\frac{1}{V} \cdot \frac{\partial V}{\partial T} \qquad (7)$$

Temperature independence is necessary in order to fulfill the accuracy requirements of the sensor, e.g. in high voltage substation applications or in the measurement of high dc currents.
In order to accommodate for manufacturing tolerances, one may use the condition

$$\left| B + \frac{1}{V} \cdot \frac{\partial V}{\partial T} \right| < t \qquad (7')$$

with $t$ being a threshold value smaller than $7 * 10^{-5}$ 1/K, in particular smaller than $2 * 10^{-5}$ 1/K.
Bend-induced and/or packaging related strews and thus birefringence in the sensing fiber may result in a further contribution $H$ to the temperature dependence of the sensor, i.e. $H$ is the temperature dependence of the sensor scale factor associated with effects of birefringence present in the sensing fiber or with effects from packaging the sensor for application as a measurement device. Thus, a more general version of Eq. (7) is given by:

$$B = -\left( \frac{1}{V} \cdot \frac{\partial V}{\partial T} + H \right) \qquad (7'')$$

In order to accommodate for manufacturing tolerances, one may use the condition

$$\left| B + H + \frac{1}{V} \cdot \frac{\partial V}{\partial T} \right| < t \qquad (7''')$$

with $t$ being a threshold value smaller than $7 * 10^{-5}$ 1/K, in particular smaller than $2 * 10^{-5}$ 1/K.
Required Modifications to Eq. 7'' to achieve temperature compensation at large magneto-optic phase shifts are explained in the next section.

*Large Faraday phase shifts $\varphi_F$*

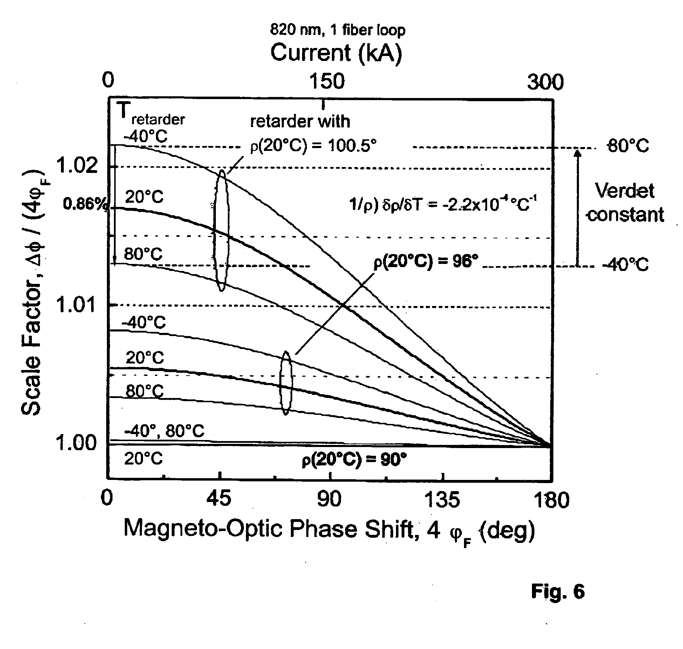

In eq. (7), (7') and (7'') or (7''') it was assumed that the Faraday phase shift $\varphi_F$ is small ($\varphi_F << 1$). The approximation holds reasonably well within the range $\varphi_F \approx < 0.3$ rad, in particular $< 0.1$ rad, in many practical situations. Significantly larger phase shifts ($\varphi_F > 0.3$ rad) may be encountered e.g. in the electrolytic production of metals, for example at aluminum smelters, where currents up to about 500 kA must be measured. Here the term $4\varphi_F$ may reach values up to e. g. $2\pi$. As it is obvious from eq. (3) - (5) the scale factor $S$ is then not only a function of $\varepsilon$, $\delta$, and $\beta$, but also depends on $\varphi_F$ and thus on the current. This is illustrated in Fig. 6, which shows the scale factor $S$ as a function of $4\varphi_F$ for three different retardations $p = \pi/2 + \varepsilon$ of the retarder ($p = 90°$, $96°$, $100.5°$) with $Q = (1/\rho) \delta\rho/\delta T = -2.2x10^{-4}°C^{-1}$. The linear birefringence $\delta$ in the sensing fiber is assumed to be zero. With $\rho = 100.5°$ the sensor is temperature-compensated for small magneto-optic phase shifts $\varphi_F$. Here, the scale factor $S = \Delta\phi/4\varphi_F$ decreases by 0.86% from 1.0216 to 1.0130, if the temperature rises from -40°C to 80°C, which just balances the relative increase in the Verdet constant with temperature (vertical arrows in Fig. 6). At increasing magneto-optic phase shifts the low and high temperature curves start to converge and finally cross-each other at $4\varphi_F = \pi$ (corresponding to $I = 300$ kA for one fiber loop and a wavelength of 820 nm). As a result, the temperature compensation is only partial at a large phase shift and finally disappears at $4\varphi_F = \pi$. However, the retarder may be prepared for optimum temperature compensation at an intermediate Faraday phase shift, e.g. at $4\varphi_F = \pi/2$. The sensor will then be somewhat overcompensated below $4\varphi_F = \pi/2$ and under-compensated above. It is obvious from Fig. 6 that temperature compensation at an intermediate Faraday phase shift requires a value of $\rho$ that is somewhat higher than the value needed for temperature compensation at $\varphi_F \ll 1$.

In general, one tunes, for a given set of parameters $\delta$, $\beta$, and $Q$, the retardation $\rho$ to a value that provides optimum temperature compensation of the Faraday effect at a desired value of the magneto-optic phase shift $4\varphi_F$. Even though the sensor is now compensated for a larger magneto-optic phase shift, the retarder tuning can still be done at small magnetic fields with $\varphi_F \ll 1$. The target temperature dependence $B$ to calculate the target signal $\sigma_{fin}$ must then be replaced by $B' = B + \Delta B$ where $\Delta B$ accounts for the difference between $B$ at small magneto-optic phase shifts ($\varphi_F \ll 1$) and $B$ at the value $4\varphi_F$ where optimum temperature compensation is to be achieved.

*Conventional retarder fabrication method*

In a state-of-the-art retarder fabrication procedure, the retarder is fabricated with an initial overlength. The retardation is then fine-tuned (reduced) in a stepwise manner until the targeted temperature dependence is reached. An initial over-length is chosen in order to cope with tolerances in the fabrication process. Fine-tuning is done by thermally treating (i.e. heating) the retarder in the arc or heater filament of a fiber splicer. The heating alters the retarder's birefringence and thus its retardation. After each fine-tuning step the retarder's contribution to the temperature dependence of the sensor is measured. The measurement involves translating the retarder to a temperature controller, changing the retarder temperature within a certain range, and measuring the sensor signal at a constant current as a function of the retarder temperature The fine-tuning is continued until proper compensation is reached. Such a procedure is relatively time consuming.

*Improved retarder fabrication method*

It is an objective of this invention to teach a more efficient fabrication method. Particularly, time consuming re-measurement of the temperature dependence after each tuning step shall be avoided. Rather, only the change of a sensor signal $\sigma$ is measured, which can be carried out repeatedly during the fine tuning process without moving the fiber or any other part.

The scale factor $S$ and thus $\sigma$ vary with the retardation $\rho$. Signal $\sigma$ may therefore serve as a measure for the contribution $B$ of the retarder to the temperature dependence of the sensor (assuming that the temperature of the sensing fiber is kept constant).

The procedure requires that the temperature dependence $Q$ of the retardation $\rho$ given by

$$Q = \frac{1}{\rho}\frac{\partial\rho}{\partial T} \qquad\qquad (8)$$

and that the initial dependence A of the sensor signal $\sigma$ on a retarder temperature given by

$$A = \frac{1}{\sigma}\frac{\partial\sigma}{\partial T} = \frac{1}{S_{ini}}\frac{\partial S_{ini}}{\partial T} \qquad\qquad (9)$$

need to be known. A method to measure the property $Q$ of the retarder fiber and the fiber beat length $L_B$, is described in the next section. A can be measured by monitoring signal $\sigma$ while varying the temperature of retarder 4.

The retarder adjustment is commonly done at small magneto-optic phase shifts ($4\varphi_F \ll 1$). The scale factor $S$ as a function of $\varepsilon$ is then given by $S(\varepsilon) = 1/\cos(\varepsilon)$ as is shown in Fig. 4 (according to [1]). The retardation $p = \pi/2 + \varepsilon$ varies with temperature according to

$$\rho(T) = \rho_0 \cdot (1 + Q \cdot \Delta T) \qquad\qquad (10)$$

and hence

$$\varepsilon(T) = \varepsilon_0 + \Delta\varepsilon(T) = \varepsilon_0 + \rho \cdot Q \cdot \Delta T \qquad (11)$$

with $\rho_0 = \rho(T_0)$ and $\varepsilon_0 = \varepsilon(T_0)$, which is depicted as well in the Fig. 4. $T_0$ usually is the room temperature, and $\Delta T = T - T_0$. The initial dependence $A(\varepsilon)$ on the retarder temperature of the the initial scale factor $S_{ini}$ and sensor signal $\sigma$ may be-expressed as:

$$A = \frac{1}{S_{ini}}\frac{\partial S_{ini}}{\partial T} = \frac{1}{S_{ini}}\frac{\partial S_{ini}}{\partial \varepsilon}\frac{\partial \varepsilon}{\partial T} = \frac{1}{S_{ini}}\frac{\partial S_{ini}}{\partial \varepsilon}\cdot Q(\varepsilon + \frac{\pi}{2}) \qquad (12)$$

The combination of Eqs. (6) and (12) allows one to express the initial normalized scale factor $S_{ini}$ ($A$, $Q_1$) as a function of the initially measured temperature dependence $A$ of the sensor signal $\sigma$ and the initial retarder temperature dependence $Q_1$. Similarly, the final normalized scale factor $S_{fin}$ ($B$, $Q_2$) may be expressed as a function of the target scale factor temperature dependence $B$ (and target temperature dependence of signal $\sigma$), and the retarder temperature dependence $Q_2$ after fine tuning, with $B$ being defined as

$$B = \frac{1}{\sigma}\frac{\partial \sigma}{\partial T} = \frac{1}{S_{fin}}\frac{\partial S_{fin}}{\partial T} \qquad (13)$$

The retarder temperature dependencies $Q_1$ and $Q_2$ before and after fine tuning, respectively, may slightly differ due to possible changes in fiber properties as a result of the thermal treatment of the fiber.

The target signal $\sigma_{fin}$, can be obtained from the initially measured sensor signal $\sigma_{ini}$ and from the ratio of the calculated scale factor $S_{ini}$ ($A$, $Q_1$) and $S_{fin}$ ($B$, $Q_2$)) according to:

$$\sigma_{fin} = \sigma_{ini}\cdot\frac{S\left(B/Q_2\right)}{S\left(A/Q_1\right)} = \sigma_{ini}\cdot r\left(A, B, Q_1, Q_2\right) \qquad (14)$$

A detailed derivation of the equations can be found in the section "Derivation of equations", below.
The retarder fabrication and tuning procedure may thus be summarized as follows:

1. Fabricate retarder connected to sensing fiber with retarder having an initial retardation larger than the proper retardation needed for the target temperature dependence $B$ of the scale factor.
2. Measure initial dependence A of sensor signal $\sigma$ on retarder temperature
3. Measure initial sensor signal $\sigma_{ini}$ at a given magnetic field (or current)
4. Calculate target sensor signal $\sigma_{fin}$ according to (14)
5. Fine-tune, measure again sensor signal $\sigma$
6. Repeat fine tuning until calculated target sensor signal $\sigma_{fin}$ is reached
7. Measure dependence of sensor signal $\sigma$ on retarder temperature for confirmation that target temperature dependence $B$ has been achieved.

Advantageously, the sensor fiber is kept straight during the above procedure in order to minimize the bend-induced linear birefringence $\delta$ Afterwards, the fiber is bent to the final coil with the desired number of fiber loops. Alternatively, the sensing fiber is kept bent in a way that generates the same amount of linear birefringence as present in the final coil during the above procedure. In the latter case, the azimuth angle $\beta$ may already be set to the value foreseen in the final coil assembly.

*Characterization of fiber properties*

The above procedure for setting the correct retardation ρ requires that the thermal coefficients of the retardation $Q_1$ and $Q_2$ before and after fine-tuning are known. This section describes a method for measuring these values for a given type of fiber. Even though, $Q_1$ and $Q_2$ can be assumed to be approximately equal, it may be advantageous to take into account that the retarder's temperature coefficient may be altered to some degree by thermal treatment.

The measurement setup is depicted in Fig. 5. A depolarized beam of low coherence light from source 8, e.g, from a super luminescent diode (SLD), with depolarizer 9 is fed into a fiber polarizer 10. The polarized light is then coupled, with the polarization direction parallel to one of the birefringent axes, into a PM fiber 11 followed by phase retarder 4 of length L under test. Retarder 4 is fabricated at the end of the fiber 11 as described in EP 1107029 with the difference that the subsequent fiber 12 is not a low-birefringence sensing fiber but another polarization maintaining fiber. The birefringent axes of fiber sections 11 and 12 are at 45° to the axes of retarder 4. Fiber 12 strips cladding modes that may be generated at the retarder and introduces a group delay between its orthogonal modes much larger than the coherence length of the low coherent light source.

The light from second PM fiber 12 is sent through a rotating analyzer (i.e. a rotating linear polarizer) 13 and then detected in detector 14. The detector signal is proportional to $D = [1 + \sin(h+p) \cdot \cos(\rho)]$, where $p$ is the (rotating) angle (0° - 360°) of the analyzer, $h$ is a constant phase corresponding to the arbitrary fiber orientation with respect to the zero position of the analyzer and ρ is again the differential retardation of retarder 4.

Retarder 4 is placed on a temperature controller 15, such as a Peltier element. By changing the temperature of retarder 4, and recording $D$, the variation of the retardation ρ with temperature and thus the value of $Q$ can be determined. The chosen length of retarder 4 is arbitrary for the purpose of the characterization. Measusing several retarders with different lengths $L$ allows for a convenient and accurate way to determine the beat length $L_B$ of the PM fiber by fitting $\rho(L) = 2\pi \cdot (L-b)/L_B$ to the measured data. The fitting parameter b accounts for fiber modifications at the splices.

The method can also be used to determine the effect of the thermal treatment of the retarder on the fiber temperature dependence $Q$.

*Derivation of equations*

As mentioned, and as shown in Fig. 4, the sensor scale factor $S$ shows a dependence on ε of $S(\varepsilon) = 1/\cos(\varepsilon)$ (for $\varphi_F \ll 1$ and for δ=0°).

The temperature coefficient $Q$ of the retardation ρ (see Eq (8)) is typically on the order of $Q = (-1...-6) \cdot 10^{-4}$ K$^{-1}$ for elliptical core fibers.

The quantity $\varepsilon = \rho - \pi/2$ changes with temperature as given by Eqs. (10) and (11).

The temperature dependence $A$ of Eq. (12) can be determined experimentally:

The normalized scale factor $S$ in an approximation for small currents is given by [2]:

$$S = \frac{\Delta\phi}{4\varphi_F} = \frac{1 + \frac{1}{3}\delta^2 + \frac{4}{3}\varphi_r^2}{\cos(\varepsilon) - \delta\sin(\varepsilon)\sin(2\beta)(1 + \frac{1}{3}\delta^2 + \frac{4}{3}\varphi_r^2)} \qquad (15)$$

We assume that the formula for the scale factor and its temperature dependence should be accurate to a level of $10^{-4}$. In a retarder fabrication setup, the measured Faraday angle is usually small, i.e. $\varphi_F < 0.01$ [rad] and the bend induced linear birefringence is small as well, i.e. $\delta < 2° \sim 0.04$ [rad]. The magnitude of ε usually is $\varepsilon < 12° - 0.2$. If only keeping terms $> 10^{-4}$ the Eq. (15) can be simplified:

$$S(\varepsilon) = \frac{\Delta\phi}{4\varphi_F} = \frac{1 + \frac{1}{3}\delta^2}{\cos(\varepsilon) - g\delta\sin(\varepsilon)} \quad with \quad g = \sin(2\beta) \qquad (16)$$

which coiresponds to Eq (6)

An even more simplified approximation of the scale factor $S$ would be:

$$S(\varepsilon) = \frac{\Delta\phi}{4\varphi_r} = 1 + \tfrac{1}{2}\varepsilon^2 + \tfrac{1}{3}\delta^2 + \delta\sin(\varepsilon)\sin(2\beta).$$

The temperature dependence using Eq. (12) now becomes:

$$A = \frac{1}{S}\frac{\partial S}{\partial \varepsilon}\cdot Q\left(\varepsilon + \frac{\pi}{2}\right) = \frac{\sin(\varepsilon) + g\delta\cos(\varepsilon)}{\cos(\varepsilon) - g\delta\sin(\varepsilon)}\cdot Q\left(\varepsilon + \frac{\pi}{2}\right)$$

After a Taylor approximation for the terms containing the small quantity $\varepsilon$ up to second order a quadratic equation can be derived:

$$\frac{A}{Q} = \frac{\varepsilon^2\left(1 - g\delta\frac{\pi}{4}\right) + \varepsilon\left(g\delta + \tfrac{\pi}{2}\right) + g\delta\cdot\tfrac{\pi}{2}}{1 - g\delta\varepsilon - \tfrac{\varepsilon^2}{2}}. \qquad (17)$$

This allows calculating the value of $\varepsilon$ for a measured dependence $A$ of the sensor signal $\sigma$ on the temperature at the retarder $Q$ is known from the characterization of the retarder fiber and $\delta$ and $\beta$ are known from geometrical considerations [2]. The quadratic equation can be solved for $\varepsilon$:

$$\varepsilon = \frac{-b + \sqrt{b^2 - 4ac}}{2a} \qquad (18)$$

With

$$a = 1 + \frac{1}{2}\frac{A}{Q} - \sin(2\beta)\delta\frac{\pi}{4}$$

$$b = \frac{\pi}{2} + \sin(2\beta)\delta\left(1 + \frac{A}{Q}\right)$$

$$c = \sin(2\beta)\delta\frac{\pi}{2} - \frac{A}{Q}$$

Hence, we can calculate the initial normalized scale factor $S_{ini} = S(A/Q_1, \delta, \beta)$ from the above formulas (16) and (18). The error introduced by the second order approximation compared to a third order Taylor development (and then solving a cubic equation) is small ($\Delta\varepsilon/\varepsilon \sim 10^{-3}$) With the target dependence $B$ of the sensor signal $a$ on the retarder temperature known, usually $B = -7\cdot10^{-5}/K$ to compensate for the Verdet constant change, and the given temperature dependence of the retardation after fine tuning $Q_2$, the final normalized scale factor $S_{fin} = S(B/Q_2, \delta, \beta)$ can be calculated with the same formulas (16) and (18). Ratio $r$ in (14) can then be calculated according to:

$$r(A, B, Q_1, Q_2) = \frac{S\left(B/Q_2, \delta, \beta\right)}{S\left(A/Q_1, \delta, \beta\right)} \qquad (19)$$

*Literature*

[1] K. Bohneit, P. Gabus, J. Nehring, H. Brändle, "Temperature and Vibration Insensitive Fiber-Optic Current Sensor", J. Lightwave Technol., 20(2), 267, (2002).
[2] K. Bohnert, P. Gabus, J. Nehring, H. Brändle, M. Brunzel, "Fiber-Optic Current Sensor for Electrowinning of Metals", J. Lightwave Technol., 25(11), 3602, (2007).
[3] J. Noda, K. Okamato, Y. Sasaki, "Polarization maintaining fibers and their applications", J. Lightwave Technol., 4, 1071, (1086).
[4] H. Lefevre, "The Fiber-Optic Gyroscope", Artech House, London, 1993.
[5] K. Bohnert, R. Wüest, A. Frank, P. Gabus, S. Wiesendanger, J. Nehring, H. Brändle, "Experimental and theoretical investigation of the high current regime of an interferometric fiber-optic current sensor", Proceedings of IEEE Sensors 2008.

Reference numbers and symbols

1: control unit
2: pm fiber (polatization-maintaining fiber)
3: sensing head
4: retarder
5: sensing fiber
6: conductor
7: reflector
8: light source
9: depolarizer
10: polarizer
11, 12: PM fibers
13: rotating analyzer
14: light detector
15: temperature controller

$\sigma$: sensor signal
$A$: initial dependence of the sensor signal on retarder temperature
$B$: final dependence of the sensor signal on retarder temperature
$\Delta B$: difference in B at different magneto-optic phase shifts
$b$: fitting parameter
$D$: detected light intensity
$h$: phase shift
$I$: current
$L$: length of retarder
$L_B$: beat length
$N$: number of sensing fiber loops
$p$: rotating angle of analyzer
$Q$: temperature dependence of retardation $\rho$
$Q_1$, $Q_2$ temperature dependence of $\rho$ before/after thermal treatment of retarder (retarder tuning)
$r$: ratio between $\sigma_{ini}$ and $\sigma_{fin}$
$S$: normalized scale factor
$\sigma_{ini}$ : sensor signal before retarder tuning

11

$\sigma_{fin}$ : sensor signal after retarder tuning
$S_{ini}$: normalized scale factor before retarder tuning
$S_{fin}$ : normalized scale factor after retarder tuning
$T$: temperature
$U$: see Eq. (4)
$V$: Verdet constant of sensing fiber

$\beta$: azimuth angle of the retarder
$\delta$: birefringence-induced phase shift in sensing fiber
$\epsilon$: additional phase shift of retarder (deviation from $\pi/2$)
$\rho$: phase shift of retarder

**Claims**

1. A method of manufacturing a fiber optic current sensor, which fiber optic current sensor comprises
   a sensing fiber (5) to be exposed to a magnetic field of a current Ito be measured, wherein said sensing fiber (5) has a Verdet constant $V$ and a birefringent linear phase retardation $\delta$,
   at least one fiber optical retarder(4) coupled to said fiber (5) for converting light between linear and elliptical polarization, wherein a slow axis of said retarder is at an angle 45° - $\beta$ in respect to a slow axis of said sensing fiber, and wherein a differential retardation $\rho$ induced by said retarder is dependent on temperature with

$$Q = \frac{1}{\rho} \cdot \frac{\partial \rho}{\partial T},$$

and a control unit (1) adapted to generate a sensor signal $\sigma$ dependent on a current-induced phase shift $\Delta\phi$, in particular proportional to said phase shift $\Delta\phi$, which phase shift can be written as

$$\Delta\phi = 4 S \cdot \varphi_F$$

with $\varphi_F = V \cdot N \cdot I$, and wherein $N$ is a number of loops of said sensing fiber (5) and $S$ is a scale factor,
said method comprising the steps of exposing said sensing fiber (5) to a magnetic field, in an initial step, measuring a dependence A

$$A = \frac{1}{\sigma} \cdot \frac{\partial \sigma}{\partial T}$$

of said sensor signal $\sigma$ on a temperature $T$ of said retarder (4),
defining a target dependence

$$B = \frac{1}{\sigma} \cdot \frac{\partial \sigma}{\partial T}$$

of the sensor signal $\sigma$ on the temperature $T$ of said retarder
determining, from $A, B, Q, \delta$ and $\beta$, a ratio $r$ with

$$r = \frac{\sigma_{fin}}{\sigma_{ini}}$$

between an initial sensor signal $\sigma_{ini}$ before a thermal treatment of said retarder(4) and a target sensor signal $\sigma_{fin}$ after a thermal treatment of said retarder (4), and
subjecting said retarder (4) to said thermal treatment and measuring said sensor signal $\sigma$ until said sensor signal $\sigma$ has substantially changed by said ratio $r$.

2. The method of claim 1 wherein said ratio $r$ is calculated from

$$r(A,B,Q_1,Q_2,\delta,\beta) = \frac{S\left(\frac{B}{Q_2},\delta,\beta\right)}{S\left(\frac{A}{Q_1},\delta,\beta\right)}$$

with $B$ being a target dependence of said sensor signal $\sigma$ on the temperature of said retarder (4), $Q_1$ and $Q_2$ being values of $Q$ before and after said thermal treatment of retarder (4), respectively, and $S$ being a normalized scale factor given by

$$S = \frac{\Delta\phi}{4VNI} = \frac{\Delta\phi}{4\varphi_F}$$

with

$$\Delta\phi = \arctan\left(\frac{2U}{1-U^2}\right)$$

$$U = \frac{2\varphi_F \frac{\tan(\Gamma)}{\Gamma}}{\cos(\varepsilon) - \delta\sin(\varepsilon)\sin(2\beta)\frac{\tan(\Gamma)}{\Gamma}}$$

$$\Gamma = \left[\delta^2 + (2\varphi_F)^2\right]^{1/2}$$

or an approximation thereof, with

$$\varepsilon = \frac{-b + \sqrt{b^2 - 4ac}}{2a}$$

with

$$a = 1 + \frac{1}{2}X - \sin(2\beta)\delta\frac{\pi}{4}$$

$$b = \frac{\pi}{2} + \sin(2\beta)\delta(1 + X)$$

$$c = \sin(2\beta)\delta\frac{\pi}{2} - X$$

wherein $X = A/Q_1$ when calculating $S$ before thermal treatment and $X = B/Q_2$ when calculating $S$ after thermal treatment, with $Q_1$ and $Q_2$ denoting values of $Q$ before and after the thermal treatment.

3. The method of claim 2, wherein said approximation is

$$S = \frac{1 + \frac{1}{3}\delta^2}{\cos(\varepsilon) - \delta\sin(\varepsilon)\sin(2\beta)} \quad .$$

4. The method of any of the preceding claims 2 or 3, wherein said values $Q_1$ and $Q_2$ are not equal and wherein at least one of them has been determined prior to manufacturing said sensor.

5. The method of any of the claims 2 to 4, wherein

$$\left| B + \frac{1}{V}\cdot\frac{\partial V}{\partial T} \right| < t$$

with t being a threshold value smaller than $7* 10^{-5}$ 1/K, in particular smaller than $2* 10^{-5}$ 1/K.

6. The method of any of the claims 2 to 4, wherein

$$\left| B + H + \frac{1}{V}\cdot\frac{\partial V}{\partial T} \right| < t$$

with H being a temperature dependence of the sensor scale factor associated with effects of birefringence present in the sensing fiber or with effects from packaging the sensor for application as a measurement device, with t being a threshold value smaller than $7* 10^{-5}$ 1/K, in particular smaller than $2*10^{-5}$ 1/K.

7. The method of claim 6, wherein $B$ is determined such that the sensor is temperature compensated for $\varphi_F$ <0.3 rad, particularly $\varphi_F$ <0.1 rad.

8. The method of claim 6, wherein $B$ is determined such that the sensor is temperature-compensated for $\varphi_F$ > 0.3 rad.

9. The method of any of the preceding claims wherein during manufacturing of said retarder (4), said sensing fiber (5) is substantially straight and wherein, after said manufacturing, said sensing fiber (5) is bent to form a coil consisting of N>0 loops.

**Patentansprüche**

1. Verfahren zum Herstellen eines faseroptischen Stromsensors, wobei der faseroptische Stromsensor Folgendes umfasst:

eine erfassende Faser (5), die einem Magnetfeld eines zu messenden Stroms $I$ ausgesetzt werden soll, wobei die erfassende Faser (5) eine Verdet-Konstante $V$ und eine lineare Doppelbrechungs-Phasenverzögerung $\delta$ aufweist,
mindestens einen an die Faser (5) gekoppelten faseroptischen Verzögerer (4) zum Umwandeln von Licht zwischen linearer und elliptischer Polarisation, wobei eine langsame Achse des Verzögerers unter einem Winkel 45°-$\beta$ bezüglich einer langsamen Achse der erfassenden Faser verläuft und wobei eine von dem Verzögerer induzierte Differenzverzögerung $\rho$ von der Temperatur abhängig ist mit

$$Q = \frac{1}{\rho} \cdot \frac{\partial \rho}{\partial T},$$

und eine Steuereinheit (1) ausgelegt ist zum Generieren eines Sensorsignals $\sigma$ in Abhängigkeit von einer strominduzierten Phasenverschiebung $\Delta\varphi$, insbesondere proportional zu der Phasenverschiebung $\Delta\varphi$, wobei die Phasenverschiebung geschrieben werden kann als

$$\Delta\phi = 4 S \varphi_F$$

wobei $\varphi_F = V \cdot N \cdot I$ und wobei $N$ eine Anzahl von Schleifen in der erfassenden Faser (5) ist und $S$ ein Skalenfaktor ist, wobei das Verfahren die folgenden Schritte umfasst:

die erfassende Faser (5) einem Magnetfeld aussetzen,
in einem anfänglichen Schritt eine Abhängigkeit A

$$A = \frac{1}{\sigma} \cdot \frac{\partial \sigma}{\partial T}$$

des Sensorsignals $\sigma$ von einer Temperatur $T$ des Verzögerers (4) messen,
Definieren einer Zielabhänqiqkeit

$$B = \frac{1}{\sigma} \cdot \frac{\partial \sigma}{\partial T}$$

des Sensorsignals von einer Temperatur $T$ des Verzögerers,
Bestimmen, aus $A$, $B$, $Q$, $\delta$ und $\beta$, eines Verhältnisses $r$ mit

$$r = \frac{\sigma_{fin}}{\sigma_{ini}}$$

zwischen einem anfänglichen Sensorsignal $\sigma_{ini}$ vor einer thermischen Behandlung des Verzögerers (4)

und eines Zielsensorsignals $\sigma_{fin}$ nach einer thermischen Behandlung des Verzögerers (4) und den Verzögerer (4) der thermischen Behandlung unterziehen und das Sensorsignal $\sigma$ messen, bis sich das Sensorsignal $\sigma$ im Wesentlichen um das Verhältnis $r$ geändert hat.

2. Verfahren nach Anspruch 1, wobei das Verhältnis $r$ berechnet wird aus

$$r\left(A,B,Q_1,Q_2,\delta,\beta\right)=\frac{S\left(B/Q_2,\delta,\beta\right)}{S\left(A/Q_1,\delta,\beta\right)}$$

wobei $B$ eine Zielabhängigkeit des Sensorsignals $\sigma$ von der Temperatur des Verzögerers (4) ist, $Q_1$ und $Q_2$ Werte von $Q$ vor beziehungsweise nach der thermischen Behandlung des Verzögerers (4) ist und $S$ ein normierter Skalenfaktor ist, gegeben durch

$$S=\frac{\Delta\phi}{4VNI}=\frac{\Delta\phi}{4\varphi_F}$$

mit

$$\Delta\phi=\arctan\left(\frac{2U}{1-U^2}\right)$$

$$U=\frac{2\varphi_F\frac{\tan(\Gamma)}{\Gamma}}{\cos(\varepsilon)-\delta\sin(\varepsilon)\sin(2\beta)\frac{\tan(\Gamma)}{\Gamma}}$$

$$\Gamma=\left[\delta^2+(2\varphi_F)^2\right]^{1/2}$$

oder eine Approximation davon mit

$$\varepsilon=\frac{-b+\sqrt{b^2-4ac}}{2a}$$

mit

$$a=1+\frac{1}{2}X-\sin(2\beta)\delta\frac{\pi}{4}$$

$$b=\frac{\pi}{2}+\sin(2\beta)\delta(1+X)$$

$$c = \sin(2\beta)\delta\frac{\pi}{2} - X$$

wobei $X=A/Q_1$ beim Berechnen von $S$ vor der thermischen Behandlung und $X=B/Q_2$ beim Berechnen von $S$ nach der thermischen Behandlung, wobei $Q_1$ und $Q_2$ Werte von $Q$ vor und nach der thermischen Behandlung bezeichnen.

3. Verfahren nach Anspruch 2, wobei die Approximation

$$S = \frac{1 + \frac{1}{3}\delta^2}{\cos(\varepsilon) - \delta\sin(\varepsilon)\sin(2\beta)}$$

lautet.

4. Verfahren nach einem der vorhergehenden Ansprüche 2 oder 3, wobei die Werte $Q_1$ und $Q_2$ nicht gleich sind und wobei mindestens einer von ihnen vor dem Herstellen des Sensors bestimmt worden ist.

5. Verfahren nach einem der Ansprüche 2 bis 4, wobei

$$\left| B + \frac{1}{V} \cdot \frac{\partial V}{\partial T} \right| < t$$

wobei t ein Schwellwert kleiner als $7*10^{-5}$ 1/K ist, insbesondere kleiner als $2*10^{-5}$ 1/K.

6. Verfahren nach einem der Ansprüche 2 bis 4, wobei

$$\left| B + H + \frac{1}{V} \cdot \frac{\partial V}{\partial T} \right| < t$$

wobei $H$ eine Temperaturabhängigkeit des Sensorskalenfaktors assoziiert mit Effekten der Doppelbrechung ist, die in der erfassenden Faser vorliegt, oder mit Effekten von dem Kapseln des Sensors vor der Abwendung als Messeinrichtung, wobei $t$ ein Schwellwert kleiner als $7*10^{-5}$ 1/K, insbesondere kleiner als $2*10^{-5}$ 1/K, ist.

7. Verfahren nach Anspruch 6, wobei $B$ derart bestimmt wird, dass der Sensor für $\varphi_F<0{,}3$ rad, insbesondere $\varphi_F<0{,}1$ rad, temperaturkompensiert ist.

8. Verfahren nach Anspruch 6, wobei $B$ derart bestimmt ist, dass der Sensor für $\varphi_F>0{,}3$ rad temperaturkompensiert ist.

9. Verfahren nach einem der vorhergehenden Ansprüche, wobei die erfassende Faser (5) während der Herstellung des Verzögerers (4) im Wesentlichen gerade ist und wobei die erfassende Faser (5) nach der Herstellung gebogen wird, um eine Spule auszubilden, die aus N>0 Schleifen besteht.

**Revendications**

1. Procédé de fabrication d'un capteur de courant à fibre optique, lequel capteur de courant à fibre optique comprend :

une fibre de détection (5) à exposer à un champ magnétique d'un courant I à mesurer, où ladite fibre de détection (5) a une constante de Verdet V et un retard de phase linéaire biréfringent δ,
au moins un retardateur à fibre optique (4) couplé à ladite fibre (5) pour convertir la lumière entre une polarisation linéaire et une polarisation elliptique, où un axe lent dudit retardateur fait un angle de 45°-β par rapport à un axe lent de ladite fibre de détection,
et où un retard différentiel ρ induit par ledit retardateur dépend de la température suivant l'équation :

$$Q = \frac{1}{\rho} \cdot \frac{\partial \rho}{\partial T},$$

et une unité de commande (1) adaptée pour générer un signal de capteur σ qui dépend d'un déphasage induit par un courant $\Delta\square$, en particulier proportionnel audit déphasage $\Delta\square$, lequel déphasage peut s'exprimer sous la fourme :
$\Delta\square$ = 4 S $\varphi_F$, avec $\varphi_F$ = V.N.I, et où N est un nombre de boucles de ladite fibre de détection (5) et S est un facteur d'échelle,
ledit procédé comprenant les étapes consistant à :

exposer ladite fibre de détection (5) à un champ magnétique,
dans une première étape, mesurer une dépendance A

$$A = \frac{1}{\sigma} \cdot \frac{\partial \sigma}{\partial T}$$

dudit signal de capteur σ par rapport à la température T dudit retardateur (4),
définir une dépendance cible

$$B = \frac{1}{\sigma} \cdot \frac{\partial \sigma}{\partial T}$$

du signal de capteur σ par rapport à la température T dudit retardateur,
déterminer, à partir de A, B, Q, δ et β, un rapport r avec

$$r = \frac{\sigma_{fin}}{\sigma_{ini}}$$

entre un signal de capteur initial $\sigma_{ini}$ avant traitement thermique dudit retardateur (4) et un signal de capteur cible $\sigma_{fin}$ après traitement thermique dudit retardateur (4), et
soumettre ledit retardateur (4) audit traitement thermique, et mesurer ledit signal de capteur σ jusqu'à ce que ledit signal de capteur σ ait sensiblement changé dans la proportion dudit rapport r.

2. Procédé selon la revendication 1, dans lequel ledit rapport r est calculé à partir de l'équation :

$$r\left(A, B, Q_1, Q_2, \delta, \beta\right) = \frac{S\left(B/Q_2, \delta, \beta\right)}{S\left(A/Q_1, \delta, \beta\right)}$$

avec B étant une dépendance cible dudit signal de capteur σ par rapport à la température dudit retardateur (4), $Q_1$ et $Q_2$ étant, respectivement, des valeurs de Q avant et après ledit traitement thermique du retardateur (4), et S étant un facteur d'échelle normalisé donné par :

$$S = \frac{\Delta\phi}{4VNI} = \frac{\Delta\phi}{4\varphi_F}$$

avec

$$\Delta\phi = \arctan\left(\frac{2U}{1 - U^2}\right)$$

$$U = \frac{2\varphi_F \dfrac{\tan(\Gamma)}{\Gamma}}{\cos(\varepsilon) - \delta\sin(\varepsilon)\sin(2\beta)\dfrac{\tan(\Gamma)}{\Gamma}}$$

$$\Gamma = \left[\delta^2 + (2\varphi_F)^2\right]^{1/2}$$

ou une approximation de celui-ci avec :

$$\varepsilon = \frac{-b + \sqrt{b^2 - 4ac}}{2a}$$

avec

$$a = 1 + \frac{1}{2}X - \sin(2\beta)\delta\frac{\pi}{4}$$

$$b = \frac{\pi}{2} + \sin(2\beta)\delta(1 + X)$$

$$c = \sin(2\beta)\delta\,\frac{\pi}{2} - X$$

où X = A/Q$_1$ lors du calcul de S avant traitement thermique et X = B/Q$_2$ lors du calcul de S après traitement thermique, avec Q$_1$ et Q$_2$ désignant les valeurs de Q avant et après le traitement thermique.

**3.** Procédé selon la revendication 2, dans lequel ladite approximation est :

$$S = \frac{1 + \frac{1}{3}\delta^2}{\cos(\varepsilon) - \delta\sin(\varepsilon)\sin(2\beta)}$$

**4.** Procédé selon l'une quelconque des revendications précédentes 2 ou 3, dans lequel lesdites valeurs Q$_1$ et Q$_2$ ne sont pas égales, et dans lequel au moins une d'elles a été déterminée avant de fabriquer ledit capteur.

**5.** Procédé selon l'une quelconque des revendications 2 à 4, dans lequel :

$$\left| B + \frac{1}{V} \cdot \frac{\partial V}{\partial T} \right| < t$$

avec t étant une valeur seuil inférieure à $7{*}10^{-5}$ 1/K, en particulier inférieure à $2{*}10^{-5}$ 1/K.

**6.** Procédé selon l'une quelconque des revendications 2 à 4, dans lequel :

$$\left| B + H + \frac{1}{V} \cdot \frac{\partial V}{\partial T} \right| < t$$

avec H étant une dépendance à la température du facteur d'échelle du capteur associé aux effets de la biréfringence présente dans la fibre de détection ou aux effets de mise en boîtier du capteur pour une application comme dispositif de mesure, avec t étant une valeur seuil inférieure à $7{*}10^{-5}$ 1/K, en particulier inférieure à $2{*}10^{-5}$ 1/K.

**7.** Procédé selon la revendication 6, dans lequel B est déterminé de manière à ce que le capteur soit compensé par rapport à la température pour $\varphi_F < 0{,}3$ rad, en particulier pour $\varphi_F < 0{,}1$ rad.

**8.** Procédé selon la revendication 6, dans lequel B est déterminé de manière à ce que le capteur soit compensé par rapport à la température pour $\varphi_F > 0{,}3$ rad.

**9.** Procédé selon l'une quelconque des revendications précédentes dans lequel au cours de la fabrication dudit retardateur (4), ladite fibre de détection (5) est sensiblement rectiligne et dans lequel, après ladite fabrication, ladite fibre de détection (5) est cintrée pour former une bobine constituée de N > 0 boucles.

**Fig. 1**

**Fig. 2**

plane of fiber coil

**Fig. 3**

**Fig. 4**

**Fig. 5**

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1107029 A
- EP 1115000 A

- WO 2005111533 A

### Non-patent literature cited in the description

- **K. Bohneit ; P. Gabus ; J. Nehring ; H. Brändle.** Temperature and Vibration Insensitive Fiber-Optic Current Sensor. *J. Lightwave Technol.,* 2002, vol. 20 (2), 267
- **K. Bohnert ; P. Gabus ; J. Nehring ; H. Brändle ; M. Brunzel.** Fiber-Optic Current Sensor for Electrowinning of Metals. *J. Lightwave Technol.,* 2007, vol. 25 (11), 3602

- **J. Noda ; K. Okamato ; Y. Sasaki.** Polarization maintaining fibers and their applications. *J. Lightwave Technol.,* vol. 4 (1071), 1086
- **H. Lefevre.** The Fiber-Optic Gyroscope. Artech House, 1993
- **K. Bohnert ; R. Wüest ; A. Frank ; P. Gabus ; S. Wiesendanger ; J. Nehring ; H. Brändle.** Experimental and theoretical investigation of the high current regime of an interferometric fiber-optic current sensor. *Proceedings of IEEE Sensors,* 2008